# EUROPEAN PATENT SPECIFICATION

(11) **EP 3 182 457 B1**
(45) Date of publication and mention of the grant of the patent: **06.04.2022**
(21) Application number: 16184565.6
(22) Date of filing: 17.08.2016
(51) Int. Cl.: H01L 27/32, H01L 51/52

(54) **ORGANIC LIGHT EMITTING DIODE DISPLAY DEVICE**
ANZEIGEVORRICHTUNG MIT ORGANISCHEN LEUCHTDIODEN
AFFICHAGE À DIODES ÉLECTROLUMINESCENTES ORGANIQUES

(30) Priority: 17.12.2015 KR 20150181213
(43) Date of publication of application: 21.06.2017
(73) Proprietor: LG Display Co., Ltd., Seoul 150-721 (KR)
(72) Inventor: CHOI, Howon, 413-772 Gyeonggi-do (KR); KIM, Suhyeon, 10845 Gyeonggi-do (KR); KIM, Hyesook, 08761 Seoul (KR)
(74) Representative: Morrall, Jonathan Ian McLachlan

(56) References cited:
- KR-A- 20150 136 733
- US-A1- 2011 101 857
- US-A1- 2014 184 972
- US-A1- 2015 349 029
- US-A1- 2015 349 030

## Description

### CROSS-REFERENCE TO RELATED APPLICATIONS

This application claims priority from Korean Patent Application No. 2015-0181213 filed on December 17, 2015.

### BACKGROUND

The present invention relates to an organic light emitting diode display device capable of reducing the reflectance thereof and realizing a clear black color.

### Description of the Related Art

With progress to the information-oriented society, various demands for display devices for displaying an image are increasing. Recently, various kinds of flat panel display devices such as a liquid crystal display (LCD) device, a plasma display panel (PDP) device, an organic light emitting diode (OLED) display device, etc. have been used.

Of the above-described display devices, an OLED display device can be manufactured into a lightweight and thin form since it uses a self-luminous light emitting element and thus does not need a backlight used for a liquid crystal display (LCD) device using a non-emitting element. Further, the OLED display device is excellent in viewing angle and contrast ratio and advantageous in terms of power consumption as compared with the LCD device. In addition, the OLED display device can be driven with a low DC voltage, has a high response speed and includes internal components in the form of solids. Therefore, the OLED display device has the advantages of a high resistance to external shocks, a wide category temperature range, and particularly, low manufacturing costs.

Such an OLED display device displays an image in a top-emission manner or a bottom-emission manner depending on a structure of an organic light emitting element including a first electrode, a second electrode, and an organic light emitting layer. In a bottom-emission OLED display device, a visible light generated from the organic light emitting layer is displayed on a bottom side of a substrate on which a TFT is formed, or located. On the other hand, in a top-emission OLED display device, a visible light generated from the organic light emitting layer is displayed on a top side of the substrate on which the TFT is formed, or located.

OLED display devices often include a polarizing plate including a circular polarizing plate and a linear polarizing plate, which realizes black of the OLED display device and reduces external light reflection so as to improve visibility. However, using the polarizing plate in the OLED display device is costly and reduces the brightness of the OLED display device.

Therefore, the polarizing plate disposed on or under an organic light emitting display panel would ideally be removed. However, the reflectance of the organic light emitting display panel is increased and there is deterioration in black color expression. Particularly, in an OLED display device including a white (W) sub-pixel, the white (W) sub-pixel without a color filter layer is far higher in reflectance than red (R), green (G), and blue (B) sub-pixels each including a color filter layer, which causes an increase in reflectance of the entire panel. Further, the color filter layers disposed in the red (R), green (G), and blue (B) sub-pixels cause deterioration in visual expression of a black color in the OLED display device.

Accordingly, an OLED display device capable of solving this problem has been demanded.

US 2015/0349029 A1 discloses a display panel includes a substrate with a plurality of color sub pixel regions and a white sub pixel region constituting a unit pixel; a color filter layer with a color filter provided in each of the plurality of color sub pixel regions; and a reflection reduction layer provided in the white sub pixel region. The reflection reduction layer includes at least one color filter selected from the color filter layer, and a thickness of the reflection reduction layer is smaller than a thickness of the selected color filter.

Patent document US2014184972 also discloses a display panel comprising red, green, blue and white sub-pixel areas; red, green and blue color filter layers respectively in the red, green and blue sub-pixel areas; and a dummy color filter layer disposed in the white sub-pixel area and being thinner than the red, green and blue color filter layers.

### BRIEF SUMMARY

An aspect of the present disclosure provides an organic light emitting diode display device which does not use a circular polarizing plate and a linear polarizing plate and can improve light efficiency, reduce reflectance, and improve visual expression of a black color.

The present invention is defined in independent claim 1 and its manufacturing method in independent claim 12.

The organic light emitting diode display may comprises a first electrode, an organic light emitting layer, and a second layer, wherein the first electrode is a reflective electrode and the second electrode a transparent conductive material.

The thickness of the first to third color filter layers may be 2 µm to 3 µm, and the thickness of the fourth color filter layers may be 0.1 µm to 1 µm.

The color of the color layer may alternate in a sequence that comprises the colors blue, green, and red.

The color layer that is blue may be configured to transmit light with a wavelength of 450 to 470 nm and absorb other wavelengths of light;
the color layer that is green may be configured to transmit light with a wavelength of 520 to 560 nm and absorb other wavelengths of light;
and the color layer that is red may be configured to transmit light with a wavelength of 620 to 640 nm and absorb other wavelengths of light.

The color of the color layer may alternate in a repeating sequence.

In this organic light emitting diode display device, at least two of the fourth color filter layers in the respective pixels are formed to have different thicknesses.

Further, the fourth color filter layer may be formed by laminating at least two different color layers.

Furthermore, at least two of the fourth color filter layers may include a first color layer disposed on one surface of the substrate and a second color layer disposed to be in contact with one lateral surface of the first color layer, and at least one of the fourth color filter layers may include one color layer. The lateral surface of a color layer may be considered to be the side of a color layer. Accordingly, the first color layer and the second color layer are disposed side-by-side. Joining two equally dimensioned layers so that one is disposed to be in contact with a lateral surface of the other produces a composite layer with a constant thickness.

Herein, the first color layer, the second color layer, and the one color layer may respectively have different colors.

Further, a sum of areas of color layers having the same color as the first color layer, a sum of areas of color layers having the same color as the second color layer, and a sum of areas of the one color layers may be the same as each other.

Although an organic light emitting diode display device according to the present exemplary embodiments does not include a polarizing plate, red (R), green (G), and blue (B) color filter layers are alternately disposed on different white (W) sub-pixels in different pixels. Thus, the organic light emitting diode display device has an effect of reducing the reflectance and realizing a clear black color.

Further, in the organic light emitting diode display device, color filter layers have different thicknesses and different colors alternately disposed on different white (W) sub-pixels. Thus, the organic light emitting diode display device may have an effect of tuning the reflectance and black color expression.

The organic light emitting diode display device may further comprises a black matrix disposed at a boundary between the color filter layers.

The present invention may also include a method of fabricating the above-mentioned organic light emitting diode display device, wherein the fourth color filter layers are formed using a half-tone mask.

The fabrication method may further include: fabricating a display device; assessing the color expressed when the display device is in a black state; and adjusting the fabrication method by changing the thickness of at least one of the fourth color filter layers to improve the appearance of the black state.

### BRIEF DESCRIPTION OF THE DRAWINGS

The above and other aspects, features and other advantages of the present disclosure will be more clearly understood from the following detailed description taken in conjunction with the accompanying drawings, in which:
FIG. 1 is a schematic system configuration view of an organic light emitting diode display device;
FIG. 2 is a schematic plane view of an organic light emitting diode display device according to a first exemplary embodiment;
FIG. 3 is a cross-sectional view taken along a line A-B of the organic light emitting diode display device according to the first exemplary embodiment;
FIG. 4 is a schematic plane view of an organic light emitting diode display device according to a second exemplary embodiment;
FIG. 5 is a cross-sectional view taken along a line C-D of the organic light emitting diode display device according to the second exemplary embodiment;
FIG. 6 is a schematic plane view of an organic light emitting diode display device according to a third exemplary embodiment;
FIG. 7 is a cross-sectional view taken along a line E-F of the organic light emitting diode display device according to the third exemplary embodiment;
FIG. 8 is a schematic plane view of an organic light emitting diode display device according to a fourth exemplary embodiment;
FIG. 9 is a cross-sectional view taken along a line G-H of the plane view of FIG. 8;
FIG. 10 and FIG. 11 are plane views illustrating configurations of color layers disposed in a first sub-pixel of an organic light emitting diode display device; and
FIG. 12 is a table comparing the reflectance, power consumption and black color expression of organic light emitting diode display devices and the efficiency of organic light emitting diodes according to a Comparative Example and an Example.

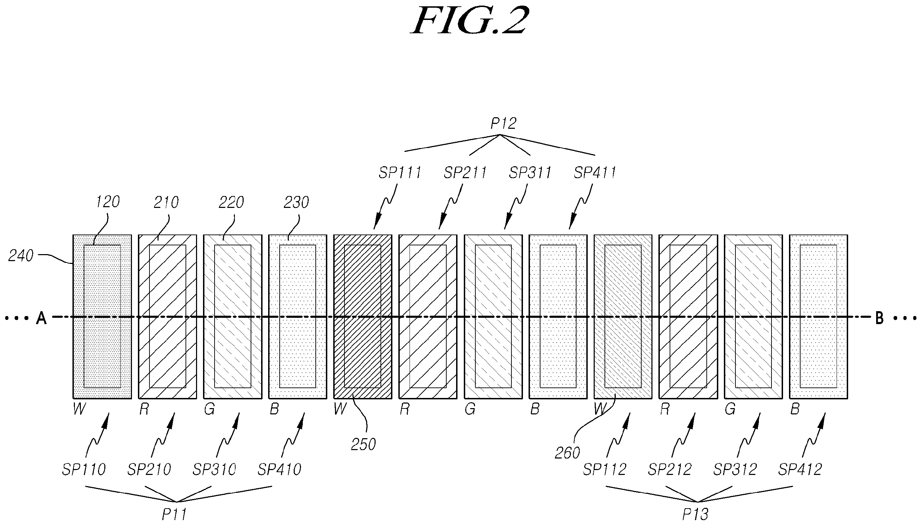

The embodiments corresponding to figures 2-3 and 6-11 are part of the present disclosure but do not form part of the present invention. However, within the present disclosure the embodiments corresponding to figures 2-3 and 6-11 are useful to understand the invention or further aspects of the invention. The invention is defined by the appended claims.

### DETAILED DESCRIPTION

Hereinafter, exemplary embodiments of the present disclosure will be described in detail with reference to the accompanying drawings. The following exemplary embodiments are provided for sufficiently conveying the concept of the present disclosure to those skilled in the art. Therefore, the present disclosure is not limited to the following exemplary embodiments themselves but can be modified and changed in other embodiments. Further, in the drawings, the size and thickness of a device may be exaggerated for convenience. Like reference numerals generally denote like elements throughout the present specification.

When an element or layer is referred to as being "on" another element or layer, it may be directly on the other element or layer, or intervening elements or layers may be present. When an element is referred to as being "directly on" another element, any intervening elements may not be present.

The spatially-relative terms such as "below", "beneath", "lower", "above", "upper", etc. may be used herein for ease of description to describe the relationship of one element or components with another element(s) or component(s) as illustrated in the drawings. It will be understood that the spatially relative terms are intended to encompass different orientations of the element in use or operation, in addition to the orientation depicted in the drawings. For example, if the element in the drawings is turned over, elements described as "below" or "beneath" other elements would then be oriented "above" the other elements. Thus, the exemplary term "below" can encompass both an orientation of above and below.

Further, in describing components of the present invention, terms such as first, second, A, B, (a), (b), etc., can be used. These terms are used only to differentiate the components from other components. Therefore, the nature, order, sequence, etc., of the corresponding components are not limited by these terms.

The embodiments corresponding to figures 2-3 and 6-11 are part of the present disclosure but do not form part of the present invention. However, within the present disclosure the embodiments corresponding to figures 2-3 and 6-11 are useful to understand the invention or further aspects of the invention. The invention is defined by the appended claims.

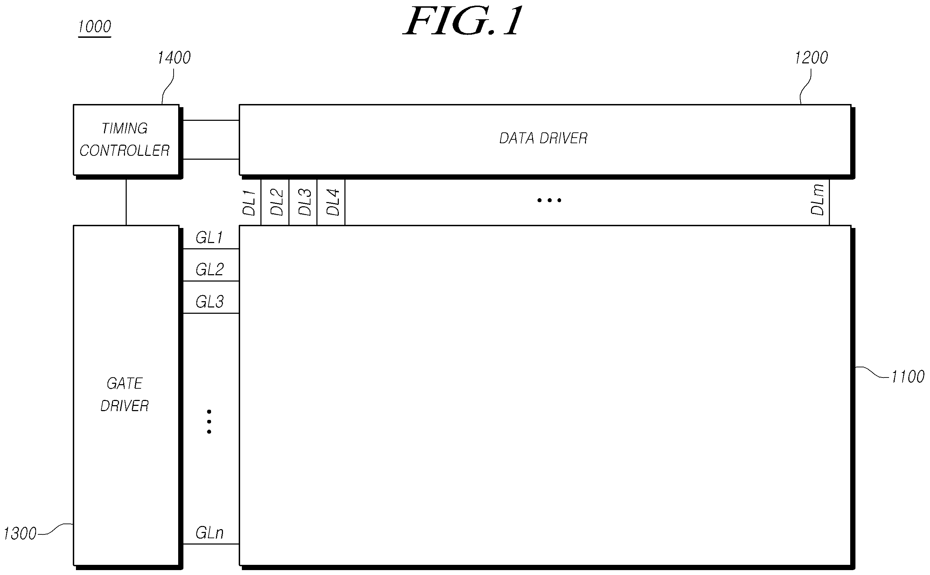

FIG. 1 is a schematic system configuration view of an organic light emitting diode display device according to the present exemplary embodiments. Referring to FIG. 1, in an organic light emitting diode display device 1000, a plurality of data lines DL to DLm and a plurality of gate lines GL1 to GLn are disposed. The organic light emitting diode display device 1000 includes an organic light emitting display panel 1100 in which a plurality of sub-pixels is disposed, a data driver 1200 configured to drive the plurality of data lines DL to DLm, a gate driver 1300 configured to drive the plurality of gate lines GL1 to GLn, and a timing controller 1400 configured to control the data driver 1200 and the gate driver 1300.

The data driver 1200 drives the plurality of data lines by supplying a data voltage to the plurality of data lines. Further, the gate driver 1300 sequentially drives the plurality of gate lines by sequentially supplying a scan signal to the plurality of gate lines.

Furthermore, the timing controller 1400 controls the data driver 1200 and the gate driver 1300 by supplying a control signal to the data driver 1200 and the gate driver 1300. The timing controller 1400 starts a scan according to timing implemented in each frame, converts image data input from the outside to be suitable for a data signal form used by the data driver 1200, outputs the converted image data, and controls a driving of data at a proper time corresponding to the scan.

The gate driver 1300 sequentially drives the plurality of gate lines by sequentially supplying an ON voltage or OFF voltage scan signal to the plurality of gate lines according to the control of the timing controller 1400. Further, the gate driver 1300 may be located at only one side of the organic light emitting display panel 1100 as illustrated in FIG. 1 or may be located at both sides thereof if necessary according to the driving method or the design of the organic light emitting display panel.

Further, the gate driver 1300 may include one or more gate driver integrated circuits. Each of the gate driver integrated circuits may be connected to a bonding pad of the organic light emitting display panel 1100 through a Tape Automated Bonding (TAB) method or a Chip On Glass (COG) method, or implemented in a Gate In Panel (GIP) type and directly disposed in the organic light emitting display panel 1100, or may be integrated and disposed in the organic light emitting display panel 1100 if necessary.

Otherwise, each of the gate driver integrated circuits may be implemented in a Chip On Film (COF) type. In this case, a gate driving chip corresponding to each gate driver integrated circuit may be mounted on a flexible film, and one end of the flexible film may be bonded to the organic light emitting display panel 1100.

If a specific gate line is opened, the data driver 1200 converts image data received from the timing controller 1400 into a data voltage of an analog form and supplies the data voltage to the plurality of data lines to drive the plurality of data lines. Further, the data driver 1200 may include at least one source driver integrated circuit to drive the plurality of data lines.

Each source driver integrated circuit may be connected to the bonding pad of the organic light emitting display panel 1100 through a Tape Automated Bonding (TAB) method or a Chip On Glass (COG) method, or directly disposed in the organic light emitting display panel 1100, or may be integrated and disposed in the organic light emitting display panel 1100 if necessary.

Otherwise, each source driver integrated circuit may be implemented in a Chip On Film (COF) type. In this case, a source driving chip corresponding to each source driver integrated circuit may be mounted on a flexible film, and one end of the flexible film may be bonded to at least one source printed circuit board and the other end thereof may be bonded to the organic light emitting display panel 1100.

The source printed circuit board may be connected to a control printed circuit board through a connector such as a flexible flat cable (FFC) or a flexible printed circuit (FPC). The timing controller 1400 is disposed in the control printed circuit board.

Further, in the control printed circuit board, a power controller (not illustrated) configured to supply a voltage or current to the organic light emitting display panel 1100, the data driver 1200, and the gate driver 1300 or control a voltage or current to be supplied may be further disposed. The above-described source printed circuit board and control printed circuit board may be formed as one printed circuit board.

In the present exemplary embodiments, a pixel includes one or more sub-pixels. For example, in the present exemplary embodiments, one pixel may include two or four sub-pixels. Colors defined in the sub-pixels may selectively include red (R), green (G), blue (B), and white (W), but the present exemplary embodiments are not limited thereto. However, one pixel of the organic light emitting diode display device 1000 according to the present exemplary embodiments may include at least one white (W) sub-pixel.

Further, an organic light emitting diode according to the present exemplary embodiments may include a first electrode, an organic light emitting layer, and a second electrode. The organic light emitting layer may be disposed in each sub-pixel or may be disposed on the entire surface of a lower substrate.

Herein, an electrode connected to a thin film transistor for controlling emission of each sub-pixel in the organic light emitting display panel 1100 is referred to as the first electrode, and an electrode disposed on the entire surface of the display panel or disposed to include two or more pixels is referred to as the second electrode. If the first electrode is an anode electrode, the second electrode is a cathode electrode, and vice versa. In the following, the first electrode will be described as an anode electrode and the second electrode will be described as a cathode electrode in an exemplary embodiment, but the present disclosure is not limited thereto.

FIG. 2 is a schematic plane view of an organic light emitting diode display device according to a first exemplary embodiment. Referring to FIG. 2, the organic light emitting diode display device according to the first exemplary embodiment includes a plurality of pixels P11, P12, P13, ···. Each of the plurality of pixels P11, P12, P13, ··· includes a plurality of sub-pixels.

The plurality of pixels P11, P12, P13, ··· illustrated in FIG. 2 will be described. Each of the pixels P11, P12, P13, ··· may include four sub-pixels. To be specific, a first pixel P11 includes a first sub-pixel SP110, a second sub-pixel SP210, a third sub-pixel SP310, and a fourth sub-pixel SP410 of the first pixel P11. Further, a second pixel P12 includes a first sub-pixel SP111, a second sub-pixel SP211, a third sub-pixel SP311, and a fourth sub-pixel SP411 of the second pixel P12. Furthermore, a third pixel P13 includes a first sub-pixel SP112, a second sub-pixel SP212, a third sub-pixel SP312, and a fourth sub-pixel SP412 of the third pixel P13.

Herein, the first sub-pixels SP110, SP111, and SP112 of the respective pixels may be white (W) sub-pixels, and the second sub-pixels SP210, SP211, and SP212 of the respective pixels may be red (R) sub-pixels. The third sub-pixels SP310, SP311, and SP312 of the respective pixels may be green (G) sub-pixels, and the fourth sub-pixels SP410, SP411, and SP412 of the respective pixels may be blue (B) sub-pixels. In FIG. 2, the sub-pixels in each of the pixels P11, P12, P13, ··· are disposed as the white (W), red (R), green (G), and blue (B) sub-pixels in sequence. However, the organic light emitting diode display device according to the first exemplary embodiment is not limited thereto, and the sub-pixels may be disposed in various sequences.

The organic light emitting diode display device according to the first exemplary embodiment is disposed on a first substrate (not illustrated). An organic light emitting diode including a first electrode 120, a white (W) organic light emitting layer (not illustrated) configured to generate a white (W) light, and a second electrode (not illustrated) may be disposed in each sub-pixel. Further, on one surface of a second substrate (not illustrated) disposed to face the first substrate (not illustrated), color filter layers 210, 220, 230, 240, 250, and 260 may be disposed corresponding to sub-pixels.

To be specific, a first color filter layer 210 may be disposed corresponding to the second sub-pixels SP210, SP211, and SP212 of the respective pixels. A second color filter layer 220 may be disposed corresponding to the third sub-pixels SP310, SP311, and SP312 of the respective pixels. A third color filter layer 230 may be disposed corresponding to the fourth sub-pixels SP410, SP411, and SP412 of the respective pixels. Herein, the first color filter layer 210 may be a red (R) color filter layer, the second color filter layer 220 may be a green (G) color filter layer, and the third color filter layer 230 may be a blue (B) color filter layer.

A polarizing plate may be provided on or under the display panel depending on an emission method of an organic light emitting display panel. The polarizing plate disposed on or under the display panel may include a linear polarizing plate and a circular polarizing plate, which reduces external light reflection so as to improve visibility of the organic light emitting diode display device. However, the polarizing plate is expensive and causes a decrease in brightness of the organic light emitting diode display device. Further, in order to increase the brightness of the organic light emitting diode display device, power consumption may also be increased.

If the polarizing plate is not disposed on or under the organic light emitting display panel, the reflectance may be increased. However, the first to third color filter layers 210, 220, and 230 disposed corresponding to the second sub-pixels SP210, SP211, and SP212, the third sub-pixels SP310, SP311, and SP312, and the fourth sub-pixels SP410, SP411, and SP412 of the respective pixels absorb external light, and, thus, the reflectance of the second sub-pixels SP210, SP211, and SP212, the third sub-pixels SP310, SP311, and SP312, and the fourth sub-pixels SP410, SP411, and SP412 of the respective pixels may be decreased.

However, due to external light reflection caused by the electrodes disposed in the first sub-pixels SP110, SP111, and SP112 of the respective pixels, the overall reflectance of the organic light emitting diode display device may be increased.

The organic light emitting diode display device according to the first exemplary embodiment is designed to solve this problem. Fourth to sixth color filter layers 240, 250, and 260 may be disposed in the first sub-pixels SP110, SP111, and SP112 of the respective pixels.

To be specific, the first color filter layer 240 may be disposed corresponding to the first sub-pixel SP110 of the first pixel P11, and the fifth color filter layer 250 may be disposed corresponding to the first sub-pixel SP111 of the second pixel P12. The sixth color filter layer 260 may be disposed corresponding to the first sub-pixel SP112 of the third pixel P13. Herein, the fourth to sixth color filter layers 240, 250, and 260 may be formed of color filter layers respectively having different colors. To be specific, the fourth to sixth color filter layers 240, 250, and 260 may be color filter layers respectively having different colors among red (R), green (G), and blue (B).

For example, as illustrated in FIG. 2, the fourth color filter layer 240 may be a blue (B) color filter layer, the fifth color filter layer 250 may be a red (R) color filter layer, and the sixth color filter layer 260 may be a green (G) color filter layer. However, the organic light emitting diode display device according to the first exemplary embodiment is not limited thereto as long as the fourth to sixth color filter layers 240, 250, and 260 are color filter layers respectively having different colors.

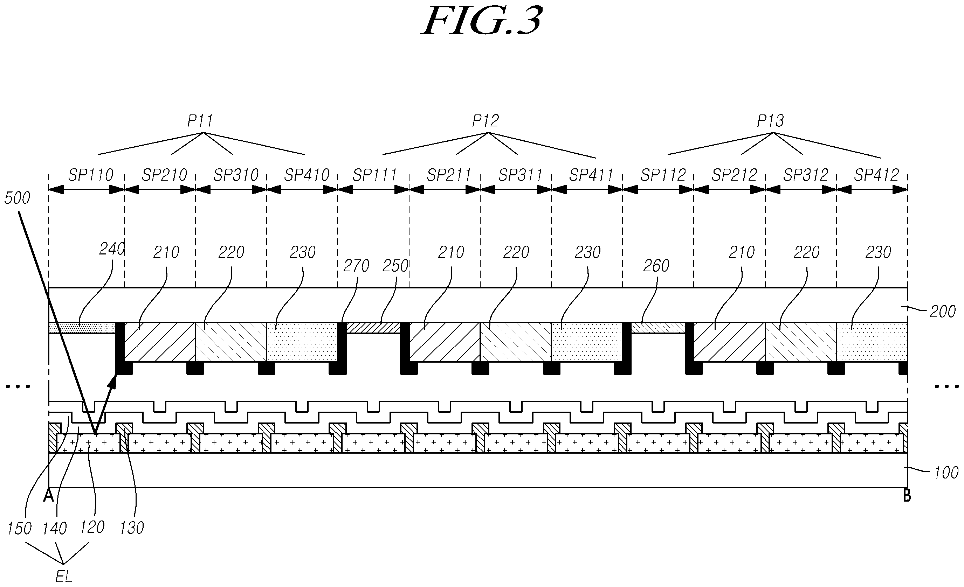

Herein, the fourth to sixth color filter layers 240, 250, and 260 may have a smaller thickness than the first to third color filter layers 210, 220, and 230. The thickness of a layer may be considered to be the shortest distance between the upper surface of the layer and the lower surface of the layer. Accordingly, there is an effect of reducing external light reflection in the first sub-pixels SP110, SP111, and SP112 of the respective pixels and improving black color expression. This configuration will be described in detail with reference to FIG. 3.

FIG. 3 is a cross-sectional view taken along a line A-B of the organic light emitting diode display device according to the first exemplary embodiment. Referring to FIG. 3, the organic light emitting diode display device according to the first exemplary embodiment includes the plurality of pixels P11, P12, P13, ···. Each of the pixels P11, P12, P13, ··· includes a plurality of sub-pixels.

The first substrate 100 is divided into a plurality of sub-pixels. At least one thin film transistor (not illustrated) may be disposed on each sub-pixel of the first substrate 100. Further, an organic light emitting diode EL electrically connected to the thin film transistor (not illustrated) may be disposed on the first substrate 100.

Herein, the organic light emitting diode EL may include the first electrode 120, an organic light emitting layer 140, and a second electrode 150. Further, a bank pattern 130 that defines an emission area and a non-emission area may be disposed on a part of a top surface of the first electrode 120.

Herein, the first electrode 120 may be a reflective electrode, and the second electrode 150 may be formed of a transparent conductive material. Further, the organic light emitting diode EL according to the first exemplary embodiment is not limited thereto. The first electrode 120 may be formed of a transparent conductive material, and the second electrode 150 may be a reflective electrode. Further, the organic light emitting layer 140 may be a white (W) organic light emitting layer that emits a white (W) light.

FIG. 3 illustrates that the first electrode 120, all of the organic light emitting layer 140, and the second electrode 150 are monolayers, but the organic light emitting diode EL according to the first exemplary embodiment is not limited thereto. At least one element may be formed of a multilayer.

Further, the organic light emitting diode display device according to the first exemplary embodiment includes a second substrate 200 disposed to face the first substrate 100. One surface of the second substrate 200 includes the color filter layers 210, 220, 230, 240, 250, and 260 disposed respectively corresponding to a plurality of sub-pixels and a black matrix 270 disposed at a boundary between the color filter layers 210, 220, 230, 240, 250, and 260.

To be specific, the first color filter layer 210 may be disposed corresponding to the second sub-pixels SP210, SP211, and SP212 of the respective pixels, and the second color filter layer 220 may be disposed corresponding to the third sub-pixels SP310, SP311, and SP312 of the respective pixels. The third color filter layer 230 may be disposed corresponding to the fourth sub-pixels SP410, SP411, and SP412 of the respective pixels. Further, the fourth color filter layer 240 may be disposed corresponding to the first sub-pixel SP110 of the first pixel P11, and the fifth color filter layer 250 may be disposed corresponding to the first sub-pixel SP111 of the second pixel P12. The sixth color filter layer 260 may be disposed corresponding to the first sub-pixel SP112 of the third pixel P13.

Herein, the first to third color filter layers 210, 220, and 230 may have a greater thickness than the fourth to sixth color filter layers 240, 250, and 260. For example, if the first to third color filter layers 210, 220, and 230 have a thickness of 2 µm to 3 µm, the fourth to sixth color filter layers 240, 250, and 260 may have a thickness of 0.1 µm to 1 µm.

That is, since the fourth to sixth color filter layers 240, 250, and 260 disposed in a region corresponding to the first sub-pixels SP110, SP111, and SP112 of the respective pixels have a smaller thickness than the first to third color filter layers 210, 220, and 230, it is possible to reduce external light reflection in the first sub-pixels SP110, SP111, and SP112 of the respective pixels without increasing power consumption.

To be specific, if the color filter layers 240, 250, and 260 disposed in the first sub-pixels SP110, SP111, and SP112 are thick, an absorption ratio of an external light 500 incident into the organic light emitting diode display device increases . However, a white (W) light generated from the organic light emitting diode EL is absorbed by the color filter layers 240, 250, and 260. Thus, the efficiency of the organic light emitting diode EL is decreased.

However, in the organic light emitting diode display device according to the first exemplary embodiment, the fourth to sixth color filter layers 240, 250, and 260 have a smaller thickness than the first to third filter layers 210, 220, and 230. Thus, it is possible to suppress a decrease in efficiency of the organic light emitting diode EL and also possible to absorb the external light 500.

Further, the color filter layers 240, 250, and 260 disposed in the region corresponding to the first sub-pixels SP110, SP111, and SP112 of the adjacent pixels have different colors. Thus, when the organic light emitting diode display device is in an OFF state, black color expression can be improved.

To be specific, the fourth color filter layer 240 may be disposed in the first sub-pixel SP110 of the first pixel P11, and the fifth color filter layer 250 may be disposed in the first sub-pixel SP111 of the second pixel P12. The sixth color filter layer 260 may be disposed in the first sub-pixel SP112 of the third pixel P13. The fourth to sixth color filter layers 240, 250, and 260 may transmit lights respectively having different wavelengths.

Herein, the fourth color filter layer 240 may transmit a light having a wavelength of 450 nm to 470 nm and absorb lights having different wavelengths from 450 nm to 470 nm. Further, the fifth color filter layer 250 may transmit a light having a wavelength of 620 nm to 640 nm and absorb lights having different wavelengths from 620 nm to 640 nm. Furthermore, the sixth color filter layer 260 may transmit a light having a wavelength of 520 nm to 560 nm and absorb lights having different wavelengths from 520 nm to 560 nm.

Therefore, if the external light 500 having a visible light wavelength is incident into the second substrate 200 of the organic light emitting diode display device, the first sub-pixel SP110 of the first pixel P11 transmits a light having a wavelength of 450 nm to 470 nm and absorbs lights having different wavelengths from 450 nm to 470 nm. Further, the light having a wavelength of 450 nm to 470 nm and incident into the first sub-pixel SP110 of the first pixel P11 is reflected by a reflective electrode (the first electrode or the second electrode according to an emission method) of the organic light emitting diode EL and changed in path toward the second substrate 200.

Most of the light having a wavelength of 450 nm to 470 nm and reflected by the reflective electrode of the organic light emitting diode EL is absorbed by the black matrix 270 or another adjacent color filter layer (for example, the first or third color filter layer). Further, the fourth color filter layer 240 may transmit a very small amount of the rest of the light having a wavelength of 450 nm to 470 nm so as to be emitted to the outside of the second substrate 200.

Further, paths of the external light 500 incident into the first sub-pixel SP111 of the second pixel P12 and the first sub-pixel SP112 of the third pixel P13 may be the same as the path of the external light 500 incident into the first sub-pixel SP110 of the first pixel P11. However, lights absorbed as the external light 500 or emitted by the first sub-pixel SP111 of the second pixel P12 and the first sub-pixel SP112 of the third pixel P13 may have wavelengths of 620 nm to 640 nm and 520 nm to 560 nm, respectively.

As described above, the fourth color filter layer 240, the fifth color filter layer 250, and the sixth color filter layer 260 are provided in the first sub-pixels SP110, SP111, and SP112 of the respective pixels. Thus, there is an effect of absorbing most of external lights and thus improving black color expression.

Although FIG. 2 and FIG. 3 illustrate only the configurations of the first to third pixels P11, P12, and P13, the first to third pixels P11, P12, and P13 may be repeatedly provided within a display region of the organic light emitting diode display device according to the first exemplary embodiment.

Further, each of the first to sixth color filter layers 210, 220, 230, 240, 250, and 260 disposed in the respective sub-pixels has any one color of red (R), green (G), or blue (B) and is formed using a half-tone mask. Thus, a color filter layer having a different thickness can be formed without an additional process. That is, regardless of thicknesses of the first to sixth color filter layers 210, 220, 230, 240, 250, and 260, the color filter layers having the same color can be formed by the same process. Therefore, it is possible to simplify a process.

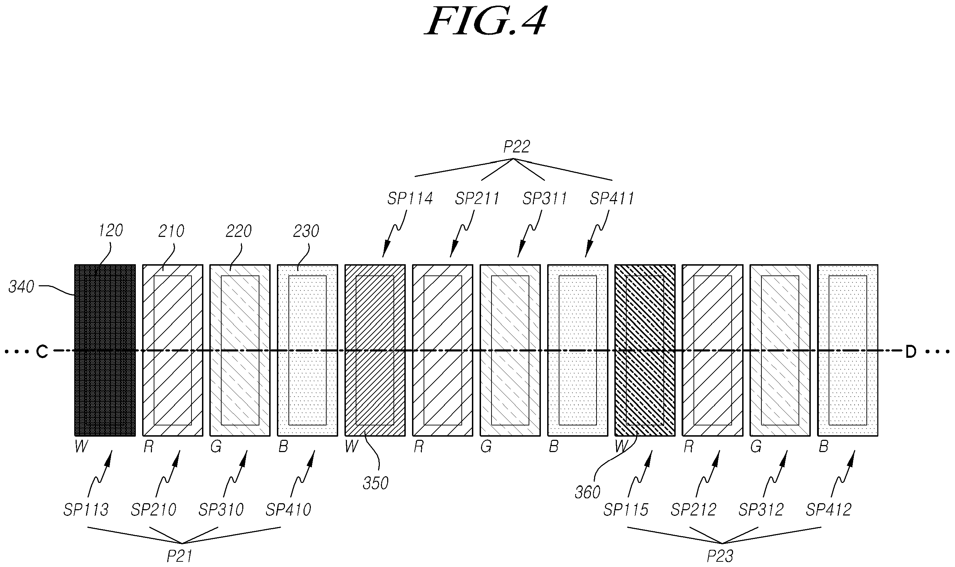

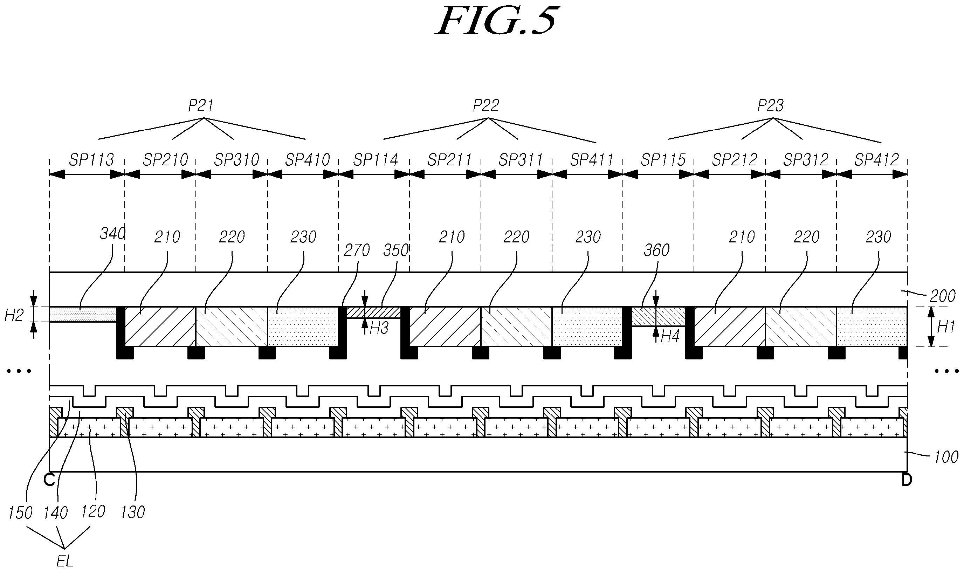

The color filter layers provided in the first sub-pixels SP110, SP111, and SP112 of the respective pixels are not limited to those illustrated in FIG. 2 and FIG. 3, and may be provided in different forms. Details thereof will be described below with reference to FIG. 4 and FIG. 5.

FIG. 4 is a schematic plane view of an organic light emitting diode display device according to a second exemplary embodiment, which embodiment forms part of the present invention.

FIG. 5 is a cross-sectional view taken along a line C-D of the organic light emitting diode display device according to the second exemplary embodiment. The organic light emitting diode display device according to the second exemplary embodiment may include the same components as those of the above-described exemplary embodiment. The redundant description thereof may be omitted herein for conciseness. Further, like components are assigned like reference numerals.

Referring to FIG. 4, the organic light emitting diode display device according to the second exemplary embodiment includes a plurality of pixels P21, P22, P23, ···. Each of the pixels P21, P22, P23, ···includes a plurality of sub-pixels.

To be specific, a first pixel P21 of the organic light emitting diode display device according to the second exemplary embodiment includes a first sub-pixel SP113, the second sub-pixel SP210, the third sub-pixel SP310, and the fourth sub-pixel SP410 of the first pixel P21. Further, a second pixel P22 includes a first sub-pixel SP114, the second sub-pixel SP211, the third sub-pixel SP311, and the fourth sub-pixel SP411 of the second pixel P22. Furthermore, a third pixel P23 includes a first sub-pixel SP115, the second sub-pixel SP212, the third sub-pixel SP312, and the fourth sub-pixel SP412 of the third pixel P23.

Herein, the first color filter layer 210 may be disposed corresponding to the second sub-pixels SP210, SP211, and SP212 of the respective pixels, and the second color filter layer 220 may be disposed corresponding to the third sub-pixels SP310, SP311, and SP312 of the respective pixels. The third color filter layer 230 may be disposed corresponding to the fourth sub-pixels SP410, SP411, and SP412 of the respective pixels.

Further, a fourth color filter layer 340, a fifth color filter layer 350, and a sixth color filter layer 360 may be disposed corresponding to the first sub-pixels SP113, SP114, and SP115 of the pixels, respectively.

Herein, the fourth to sixth color filter layers 340, 350, and 360 have a smaller height than the first to third color filter layers 210, 220, and 230. The terms "height" and "thickness" are used interchangeably herein. Further, at least two of the fourth to sixth color filter layers 340, 350, and 360 respectively have different heights.

This configuration will be described in detail with reference to FIG. 5. In FIG. 5, the first color filter layer 210 disposed in the second sub-pixels SP210, SP211, and SP212 of the respective pixels, the second color filter layer 220 disposed in the third sub-pixels SP310, SP311, and SP312 of the respective pixels, and the third color filter layer 230 disposed in the fourth sub-pixels SP410, SP411, and SP412 of the respective pixels may have the same height H1.

Further, heights H2, H3, and H4 of the fourth to sixth color filter layers 340, 350, and 360 disposed in the first sub-pixels SP113, SP114, and SP115 of the pixels, respectively, are smaller than the height H1 of the first to third color filter layers 210, 220, and 230. Thus, it is possible to suppress a decrease in efficiency of the organic light emitting diode EL in each pixel and also possible to suppress an increase in reflectance caused by the first sub-pixels SP113, SP114, and SP115.

FIG. 5 illustrates a configuration in which the first to third color filter layers 210, 220, and 230 have the same height H1. However, the organic light emitting diode display device according to the second exemplary embodiment is not limited thereto as long as the height H1 of the first to third color filter layers 210, 220, and 230 is greater than the heights H2, H3, and H4 of the fourth to sixth color filter layers 340, 350, and 360, respectively.

Further, at least two of the height H2 of the fourth color filter layer 340, the height H3 of the fifth color filter layer 350, and the height H4 of the sixth color filter layer 360 are different from each other. For example, the height H2 of the fourth color filter layer 340 may be identical to the height H4 of the sixth color filter layer 360, and the height H3 of the fifth color filter layer 350 may be smaller than the height H2 of the fourth color filter layer 340 and the height H4 of the sixth color filter layer 360. This is just an example of the organic light emitting diode display device according to the second exemplary embodiment. At least two of the heights H2, H3, and H4 of the fourth to sixth color filter layers 340, 350, and 360, respectively, just need to be different from each other.

As described above, at least two of the heights H2, H3, and H4 of the fourth to sixth color filter layers 340, 350, and 360, respectively, are different from each other. Further, in the organic light emitting diode display device according to the second exemplary embodiment, the first pixel to the third pixel P21, P22, and P23 may be repeatedly provided. Thus, it is possible to finely tune black color expression and reflectance of the organic light emitting diode display device so as to be optimized.

For example, if a bluish color is expressed when the organic light emitting diode display device is in a black state, it is possible to solve this problem by setting the thickness H2 of the fourth color filter layer 340 disposed in the first sub-pixel SP113 of the first pixel P21 to be greater than the thicknesses H3 and H4 of the fifth color filter layer 350 and the sixth color filter layer 360, respectively. To be specific, since the fourth color filter layer 340 disposed in the first sub-pixel SP113 of the first pixel P21 is formed to have the greater thickness H2, an amount of an external light incident into the first sub-pixel SP113 of the first pixel P21 may be decreased.

That is, an amount of an external light incident into the first sub-pixel SP113 of the first pixel P21, i.e., a light passing through the fourth color filter layer 340 in the first sub-pixel SP113 and having a wavelength of 450 nm to 470 nm is decreased. Thus, an amount of a reflected light (a light having a wavelength of 450 nm to 470 nm) reflected by the electrodes disposed in the first sub-pixel SP113 and emitted to the outside of the organic light emitting diode display device may also be decreased. Therefore, when the organic light emitting diode display device is in a black state, it is possible to suppress bluish color expression and also possible to reduce the reflectance.

The first sub-pixel SP113 of the first pixel has been mainly described above. However, the organic light emitting diode display device according to the second exemplary embodiment is not limited thereto. Among the plurality of pixels, in the sub-pixel where the fourth color filter layer 340 is disposed, the height H2 of the fourth color filter layer 340 may be set to be greater than the height H3 or H4 of the fifth or sixth color filter layer 350 or 360, respectively.

Further, if a reddish color is expressed when the organic light emitting diode display device is in a black state, in the sub-pixel where the fifth color filter layer 350 is disposed, the height H3 of the fifth color filter layer 350 may be set to be greater than the height H2 or H4 of the fourth or sixth color filter layer 340 or 360, respectively. Furthermore, if a greenish color is expressed when the organic light emitting diode display device is in a black state, in the sub-pixel where the sixth color filter layer 360 is disposed, the height H4 of the sixth color filter layer 360 may be set to be greater than the height H2 or H3 of the fourth or fifth color filter layer 340 or 350, respectively.

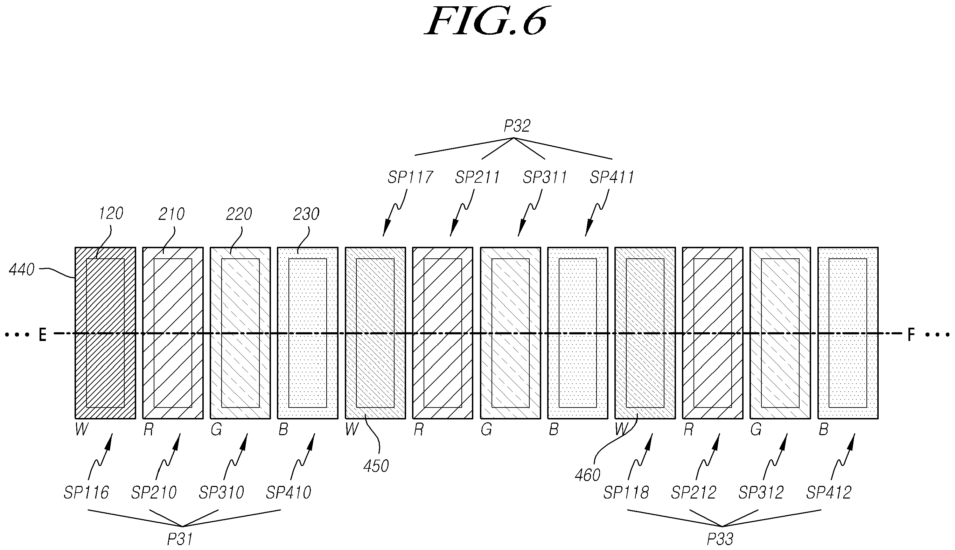

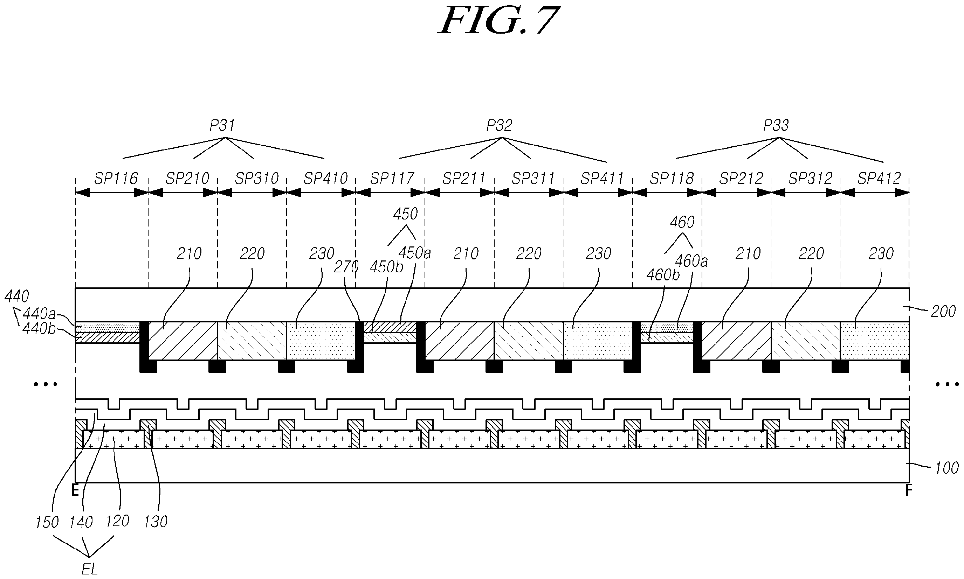

Hereinafter, an organic light emitting diode display device according to a third exemplary embodiment will be described below with reference to FIG. 6 and FIG. 7. FIG. 6 is a schematic plane view of the organic light emitting diode display device according to the third exemplary embodiment. FIG. 7 is a cross-sectional view taken along a line E-F of the organic light emitting diode display device according to the third exemplary embodiment.

The organic light emitting diode display device according to the third exemplary embodiment may include the same components as those of the above-described exemplary embodiments. The redundant description thereof may be omitted herein for conciseness. Further, like components are assigned like reference numerals.

Referring to FIG. 6, the organic light emitting diode display device according to the third exemplary embodiment includes a plurality of pixels P31, P32, P33, ···. Each of the pixels P31, P32, P33, ··· includes a plurality of sub-pixels.

To be specific, a first pixel P31 of the organic light emitting diode display device according to the third exemplary embodiment includes a first sub-pixel SP116, the second sub-pixel SP210, the third sub-pixel SP310, and the fourth sub-pixel SP410 of the first pixel P31. Further, a second pixel P32 includes a first sub-pixel SP117, the second sub-pixel SP211, the third sub-pixel SP311, and the fourth sub-pixel SP411 of the second pixel P32. Furthermore, a third pixel P33 includes a first sub-pixel SP118, the second sub-pixel SP212, the third sub-pixel SP312, and the fourth sub-pixel SP412 of the third pixel P33.

Herein, a fourth color filter layer 440, a fifth color filter layer 450, and a sixth color filter layer 460 may be disposed corresponding to the first sub-pixels SP116, SP117, and SP118 of the pixels, respectively.

Herein, at least one of the fourth to sixth color filter layers 440, 450, and 460 may be formed by laminating two or more different color layers. This configuration will be described in detail with reference to FIG. 7.

In FIG. 7, at least one of the fourth color filter layer 440, the fifth color filter layer 450, and the sixth color filter layer 460 disposed in the first sub-pixels SP116, SP117, and SP118 of the pixels, respectively, may be formed by laminating two or more different color layers.

For example, FIG. 7 illustrates that all of the fourth color filter layer 440, the fifth color filter layer 450, and the sixth color filter layer 260 are formed by laminating two different color layers. To be specific, the fourth color filter layer 440 is formed of a first color layer 440a disposed on one surface of the second substrate 200 and a second color layer 440b disposed on the first color layer 440a. Further, for example, the first color layer 440a may be a blue (B) color layer and the second color layer 440b may be a red (R) color layer, but the first and second color layers 440a and 440b are not limited thereto as long as the first and second color layers 440a and 440b respectively have different colors.

Accordingly, the reflectance of the organic light emitting diode display device can be minimized. To be specific, the fourth color filter layer 440 absorbs a light having a wavelength of 450 nm to 470 nm and a light having a wavelength of 620 nm and 640 nm among lights incident from the outside of the organic light emitting diode display device, and, thus, the reflectance can be reduced.

Further, the fifth color filter layer 450 is formed of a third color layer 450a disposed on one surface of the second substrate 200 and a fourth color layer 450b disposed on the third color layer 450a. For example, the third color layer 450a may be a red (R) color layer and the fourth color layer 450b may be a green (G) color layer, but the third and fourth color layers 450a and 450b are not limited thereto as long as the third and fourth color layers 450a and 450b respectively have different colors.

Accordingly, the fifth color filter layer 450 absorbs a light having a wavelength of 520 nm to 560 nm and a light having a wavelength of 620 nm to 640 nm among lights incident from the outside of the organic light emitting diode display device, and, thus, the reflectance can be reduced.

Further, the sixth color filter layer 460 is formed of a fifth color layer 460a disposed on one surface of the second substrate 200 and a sixth color layer 460b disposed on the fifth color layer 460a. For example, the fifth color layer 460a may be a blue (B) color layer and the sixth color layer 460b may be a green (G) color layer, but the fifth and sixth color layers 460a and 460b are not limited thereto as long as the fifth and sixth color layers 460a and 460b respectively have different colors.

Accordingly, the sixth color filter layer 460 absorbs a light having a wavelength of 450 nm to 470 nm and a light having a wavelength of 520 nm to 560 nm among lights incident from the outside of the organic light emitting diode display device, and, thus, the reflectance can be reduced.

FIG. 2 to FIG. 7 illustrate that the pixels in each of the organic light emitting diode display devices according to the first to third exemplary embodiments are disposed in a horizontal direction. However, the present exemplary embodiments are not limited thereto. The pixels may be disposed in a vertical direction.

Further, the heights of the fourth to sixth color filter layers 440, 450, and 460 formed by laminating at least two color layers may be smaller than the heights of the first to third color filter layers 210, 220, and 230. Thus, it is possible to decrease the reflectance without reducing the brightness.

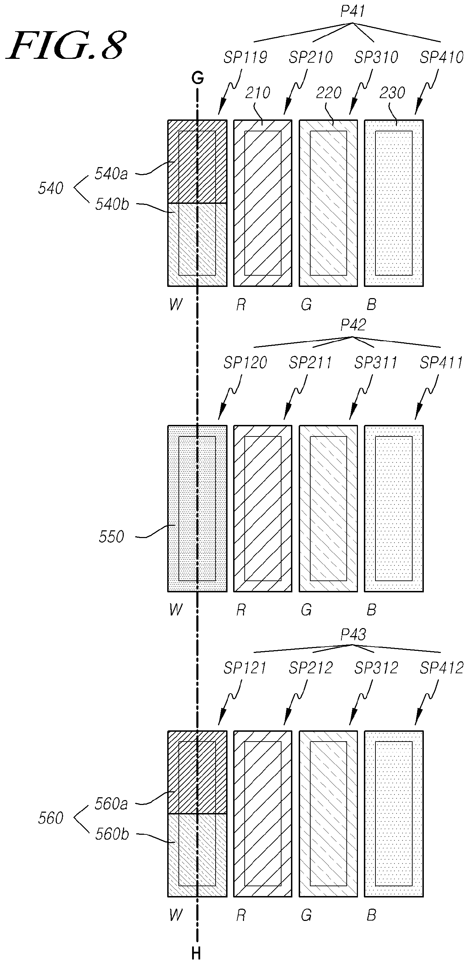

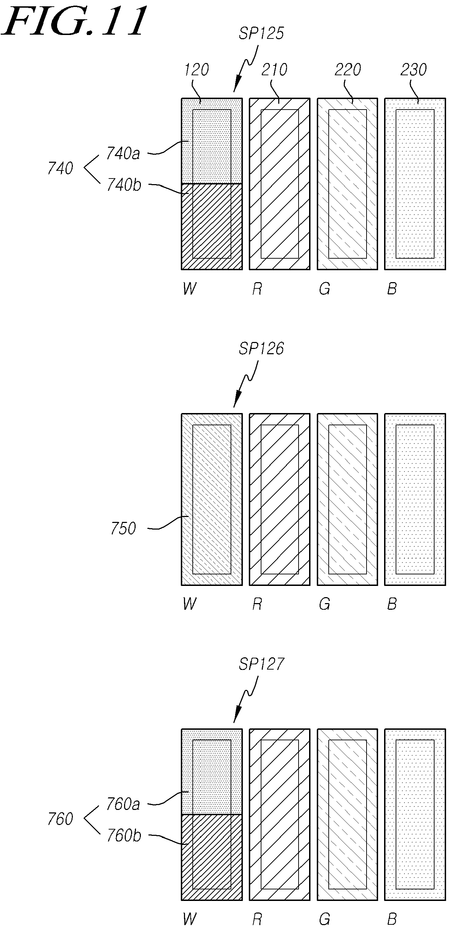

Hereinafter, an organic light emitting diode display device according to a fourth exemplary embodiment will be described below with reference to FIG. 8 and FIG. 11. The organic light emitting diode display device according to the fourth exemplary embodiment may include the same components as those of the above-described exemplary embodiments. The redundant description thereof may be omitted herein for conciseness. Further, like components are assigned like reference numerals.

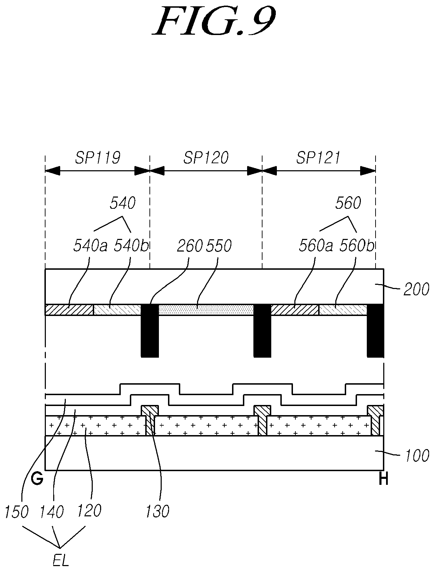

FIG. 8 is a schematic plane view of the organic light emitting diode display device according to the fourth exemplary embodiment. FIG. 9 is a cross-sectional view taken along a line G-H of the plane view of FIG. 8. Referring to FIG. 8 and FIG. 9, the organic light emitting diode display device according to the fourth exemplary embodiment includes a plurality of pixels P41, P42, P43, ···. Each of the pixels P41, P42, P43, ··· includes a plurality of sub-pixels.

To be specific, a first pixel P41 of the organic light emitting diode display device according to the fourth exemplary embodiment includes a first sub-pixel SP119, the second sub-pixel SP210, the third sub-pixel SP310, and the fourth sub-pixel SP410 of the first pixel P41. Further, a second pixel P42 includes a first sub-pixel SP120, the second sub-pixel SP211, the third sub-pixel SP311, and the fourth sub-pixel SP411 of the second pixel P42. Furthermore, a third pixel P43 includes a first sub-pixel SP121, the second sub-pixel SP212, the third sub-pixel SP312, and the fourth sub-pixel SP412 of the third pixel P43.

Herein, a fourth color filter layer 540, a fifth color filter layer 550, and a sixth color filter layer 560 may be disposed corresponding to the first sub-pixels SP119, SP120, and SP121 of the pixels, respectively. Herein, at least two of the fourth to sixth color filter layers 540, 550, and 560 may include two or more color layers, and the two or more color layers may be disposed to be in contact with one side of different color layers. Further, the two or more color layers may respectively have different colors. Furthermore, one color filter layer may include one color layer, but is not limited thereto.

Since the two or more color layers respectively have different colors, the brightness of the organic light emitting diode display device may be increased and power consumption may be decreased as compared with the case of including one color layer. To be specific, a wavelength absorbed by two or more color layers has a broader range than a wavelength absorbed by one color layer, and, thus, an external light absorption ratio of a color filter layer including two or more color layers may be increased. Therefore, even if the color filter layer is thin, the color filter layer can absorb an external light having a wavelength in a broader range. Further, since the thicknesses of at least two of the fourth to sixth color filter layers 540, 550, and 560 are decreased, the brightness of the organic light emitting diode display device can be increased and power consumption can be decreased accordingly.

For example, as illustrated in FIG. 8 and FIG. 9, the fourth color filter 540 may be disposed in the first sub-pixel SP119 of the first pixel P41, and the fourth color filter layer 540 may include a first color layer 540a and a second color layer 540b disposed on one side of the first color layer 540a. Herein, the first color layer 540a and the second color layer 540b may respectively have different colors. For example, the first color layer 540a may be a red (R) color layer and the second color layer 540b may be a green (G) color layer.

Further, the sixth color filter layer 560 disposed in the first sub-pixel S121 of the third pixel P43 may also be formed of two color layers. Herein, the sixth color filter layer 560 may include a third color layer 560a and a fourth color layer 560b disposed to be in contact with one side of the third color layer 560a. Herein, the third color layer 560a may be a red (R) color layer and the fourth color layer 560b may be a green (G) color layer.

Furthermore, the fifth color filter layer 550 may be disposed in the first sub-pixel SP120 of the second pixel P42, and the fifth color filter layer 550 may be formed of one color layer. Herein, the fifth color filter layer 550 may be formed of a blue (B) color layer.

Herein, a sum of areas of the red (R), green (G), and blue (B) color layers disposed in the first sub-pixels SP119, SP120, and SP120 of the respective pixels may be the same. That is, a sum of areas of the first color layer 540a and the third color layer 560a may be the same as a sum of areas of the second color layer 540b and the fourth color layer 560b and a sum of an area of the color layer of the fifth color filter layer 550. Thus, it is possible to express a clear black color.

Since the fourth to sixth color filter layers 540, 550, and 560 are formed as described above, when the organic light emitting diode display device is in a black state, a color of a color filter disposed in another sub-pixel cannot be seen and a clear black color can be realized. Further, it is possible to reduce the reflectance by absorbing external lights.

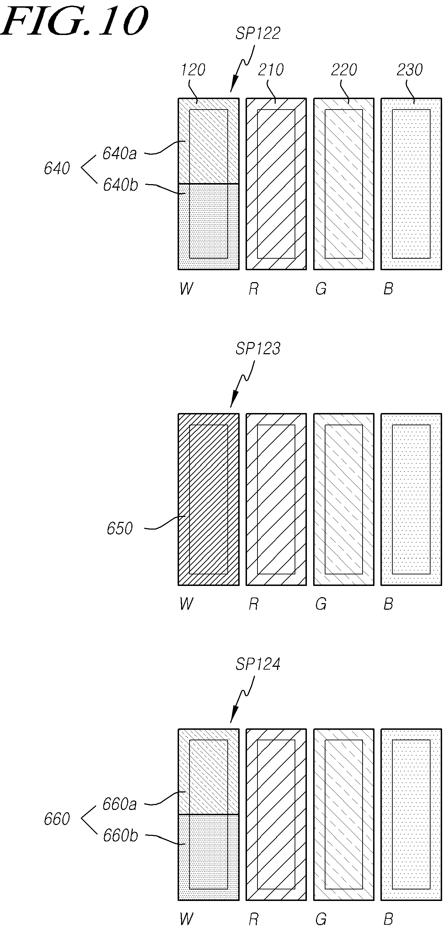

In the organic light emitting diode display device according to the fourth exemplary embodiment, each color filter included in the fourth to sixth color filter layers 540, 550, and 560 are not limited to FIG. 8 and FIG. 9 and may be formed as illustrated in FIG. 10 and FIG. 11.

FIG. 10 and FIG. 11 are plane views illustrating configurations of color layers disposed in a first sub-pixel of an organic light emitting diode display device. Referring to FIG. 10, a fourth color filter layer 640 disposed in a first sub-pixel SP122 may be formed of a first color layer 640a and a second color layer 640b. A fifth color filter layer 650 may be formed of one color layer. A sixth color filter layer 660 may be formed of a third color layer 660a and a fourth color layer 660b.

Herein, the first color layer 640a and the third color layer 660a may be green (G) color layers, and the second color layer 640b and the fourth color layer 660b may be blue (B) color layers. Further, the fifth color filter layer 650 may be formed of a red (R) color layer.

Further, in FIG. 11, a fourth color filter layer 740 disposed in a first sub-pixel SP125 may be formed of a first color layer 740a and a second color layer 740b. A fifth color filter layer 750 may be formed of one color layer. A sixth color filter layer 760 may be formed of a third color layer 760a and a fourth color layer 760b.

Herein, the first color layer 740a and the third color layer 760a may be blue (B) color layers, and the second color layer 740b and the fourth color layer 760b may be red (R) color layers. Further, the fifth color filter layer 750 may be formed of a green (G) color layer.

That is, as described above, in the organic light emitting diode display device according to the fourth example embodiment, the red (R), green (G), and blue (B) color layers disposed in the first sub-pixels of the pixels, respectively, just need to have the same sum of areas regardless of an alignment sequence of the color layers.

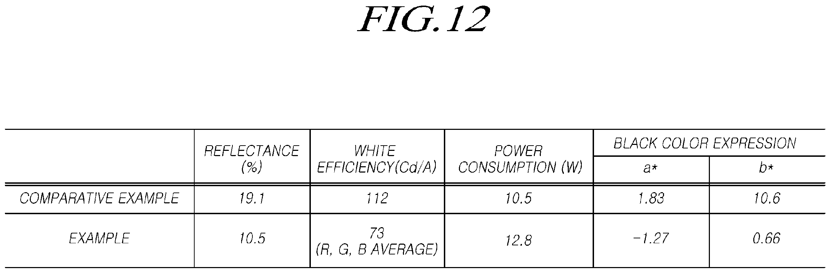

Hereinafter, referring to FIG. 12, the reflectance, power consumption and black color expression of organic light emitting diode display devices and the efficiency of organic light emitting diodes according to a Comparative Example and an Example will be described. FIG. 12 is a table comparing the reflectance, power consumption and black color expression of organic light emitting diode display devices and the efficiency of organic light emitting diodes according to the Comparative Example and the Example.

A display device according to the Comparative Example is an organic light emitting diode display device which does not include a polarizing plate and in which a color filter layer is not disposed in a white (W) sub-pixel. Further, a display device according to the Example is an organic light emitting diode display device which does not include a polarizing plate and in which a color filter layer having a smaller height than color filter layers disposed in red (R), green (G), and blue (B) sub-pixels is disposed in a white (W) sub-pixel and red (R), green (G), and blue (B) color filter layers are alternately disposed in the white (W) sub-pixel.

Referring to FIG. 12, it can be seen that the organic light emitting diode display device according to the Comparative Example has a high white efficiency, i.e., brightness and low power consumption but shows a very high reflectance and poor black color expression as compared with the organic light emitting diode display device according to the Example.

It can be seen that the organic light emitting diode display device according to the Example has a very low reflectance as compared with the organic light emitting diode display device according to the Comparative Example. Further, it can be seen that the organic light emitting diode display device according to the Example shows clear black color expression as compared with the organic light emitting diode display device according to the Comparative Example.

That is, as illustrated in FIG. 12, although the organic light emitting diode display device according to the present exemplary embodiments does not include a polarizing plate, it is possible to remarkably reduce the reflectance and also possible to realize a clear black color. The features, structures, effects, etc. described in the above exemplary embodiments are included in at least one exemplary embodiment and but are not limited to any one exemplary embodiment. In addition, the features, structures, effects, etc. described in the respective exemplary embodiments may be executed by those skilled in the art while being combined or modified with respect to other embodiments. Accordingly, it will be understood that contents related the combination and modification will be included in the scope of the present disclosure.

Further, it should be understood that the exemplary embodiments described above should be considered in a descriptive sense only and not for purposes of limitation. It will be understood by those skilled in the art that various other modifications and applications may be made therein without departing from the scope of the invention which is defined in the appended claims.

## Claims

1. An organic light emitting diode display device (1000) comprising a substrate including a plurality of pixels, wherein each pixel comprises:
red (SP210), white (SP110), green (SP310), and blue (SP410) sub-pixels;
first to third color filter layers (210,220,230) disposed on the red, green, and blue sub-pixels respectively; and a fourth color filter layer (240), including a color layer in the white sub-pixel having the same color as any one of the first to third color filter layers, and having a smaller thickness than the first to third color filter layers;
wherein the color of the color layer alternates across pixels; **characterized in that** at least two of the fourth color filter layers (340,350,360) in the respective pixels have different thicknesses.

2. The organic light emitting diode display device of claim 1, wherein the organic light emitting diode comprises a first electrode (120), an organic light emitting layer, and a second layer (150),
wherein the first electrode (120) is a reflective electrode and the second electrode is a transparent conductive material.

3. The organic light emitting diode display device of any one of the preceding claims, wherein the thickness of the first to third color filter layers is 2 µm to 3 µm, and the thickness of the fourth color filter layers is 0.1 µm to 1 µm.

4. The organic light emitting diode display device of any one of the preceding claims, wherein the color of the color layer alternates in a sequence that comprises the colors blue, green, and red.

5. The organic light emitting diode display device of claim 4, wherein:
the color layer that is blue is configured to transmit light with a wavelength of 450 to 470 nm and absorb other wavelengths of light;
the color layer that is green is configured to transmit light with a wavelength of 520 to 560 nm and absorb other wavelengths of light; and
the color layer that is red is configured to transmit light with a wavelength of 620 to 640 nm and absorb other wavelengths of light.

6. The organic light emitting diode display device of any one of the preceding claims, wherein the color of the color layer alternates in a repeating sequence.

7. The organic light emitting diode display device of any one of claims 1 to 3, 6, wherein the fourth color filter layer is formed by laminating at least two different color layers (440a,440b).

8. The organic light emitting diode display device of any one of the preceding claims,
wherein at least two of the fourth color filter layers in respective pixels include a first color layer (540a) disposed on one surface of the substrate and a second color layer (540b) disposed to be in contact with one lateral surface of the first color layer (540a), and
at least one of the fourth color filter layers in the respective pixels includes a layer of only one color (550).

9. The organic light emitting diode display device of claim 8,
wherein the first color layer (540a), the second color layer (540b), and the layer of only one color (550) respectively have different colors.

10. The organic light emitting diode display device of claim 8 or 9,
wherein a sum of areas of color layers having the same color as the first color layer (640a), a sum of areas of color layers having the same color as the second color layer (640b), and a sum of areas of one color layers (650) are the same as each other.

11. The device of any one of the preceding claims, further comprising a black matrix (270) disposed at a boundary between the color filter layers.

12. A method of fabricating any of the devices of the preceding claims, wherein the fourth color filter layers are formed using a half-tone mask.

13. The method of claim 12, wherein the method further includes:
fabricating a display device;
assessing the color expressed when the display device is in a black state; and
adjusting the fabrication method by changing the thickness of at least one of the fourth color filter layers to improve the appearance of the black state.

## Patentansprüche

1. Organische Leuchtdiodenanzeigevorrichtung (1000), die ein Substrat umfasst, das eine Mehrzahl von Bildpunkten umfasst, wobei jeder Bildpunkt umfasst:
rote (SP210), weiße (SP110), grüne (SP310) und blaue (SP410) Teilbildpunkte;
erste bis dritte Farbfilterschichten (210, 220, 230), die an den roten, grünen bzw. blauen Teilbildpunkten angeordnet sind; und eine vierte Farbfilterschicht (240), die eine Farbschicht in dem weißen Teilbildpunkt umfasst, die dieselbe Farbe wie eine beliebige der ersten bis dritten Farbfilterschichten aufweist und eine kleinere Dicke als die ersten bis dritten Farbfilterschichten aufweist;
wobei die Farbe der Farbschicht über Bildpunkte alterniert; **dadurch gekennzeichnet, dass**
mindestens zwei der vierten Farbfilterschichten (340, 350, 360) in den jeweiligen Bildpunkten unterschiedliche Dicken aufweisen.

2. Organische Leuchtdiodenanzeigevorrichtung nach Anspruch 1, wobei die organische Leuchtdiode eine erste Elektrode (120), eine organische lichtemittierende Schicht und eine zweite Schicht (150) umfasst,
wobei die erste Elektrode (120) eine rückstrahlende Elektrode ist und die zweite Elektrode ein transparentes leitendes Material ist.

3. Organische Leuchtdiodenanzeigevorrichtung nach einem der vorhergehenden Ansprüche, wobei die Dicke der ersten bis dritten Farbfilterschichten 2 µm bis 3 µm beträgt und die Dicke der vierten Farbfilterschichten 0,1 µm bis 1 µm beträgt.

4. Organische Leuchtdiodenanzeigevorrichtung nach einem der vorhergehenden Ansprüche, wobei die Farbe der Farbschicht in einer Abfolge alterniert, welche die Farben Blau, Grün und Rot umfasst.

5. Organische Leuchtdiodenanzeigevorrichtung nach Anspruch 4, wobei:
die Farbschicht, die blau ist, dazu ausgelegt ist, Licht mit einer Wellenlänge von 450 bis 470 nm zu übertragen und andere Wellenlängen von Licht zu absorbieren;
die Farbschicht, die grün ist, dazu ausgelegt ist, Licht mit einer Wellenlänge von 520 bis 560 nm zu übertragen und andere Wellenlängen von Licht zu absorbieren; und
die Farbschicht, die rot ist, dazu ausgelegt ist, Licht mit einer Wellenlänge von 620 bis 640 nm zu übertragen und andere Wellenlängen von Licht zu absorbieren.

6. Organische Leuchtdiodenanzeigevorrichtung nach einem der vorhergehenden Ansprüche, wobei die Farbe der Farbschicht in einer sich wiederholenden Abfolge alterniert.

7. Organische Leuchtdiodenanzeigevorrichtung nach einem der Ansprüche 1 bis 3, 6, wobei die vierte Farbfilterschicht durch Laminieren von mindestens zwei unterschiedlichen Farbschichten (440a, 440b) gebildet wird.

8. Organische Leuchtdiodenanzeigevorrichtung nach einem der vorhergehenden Ansprüche,
wobei mindestens zwei der vierten Farbfilterschichten in jeweiligen Bildpunkten eine erste Farbschicht (540a), die auf einer Fläche des Substrats angeordnet ist, und eine zweite Farbschicht (540b), die so angeordnet ist, dass sie in Kontakt mit einer lateralen Fläche der ersten Farbschicht (540a) ist, umfassen, und
wobei mindestens eine der vierten Farbfilterschichten in den jeweiligen Bildpunkten eine Schicht aus nur einer Farbe (550) umfasst.

9. Organische Leuchtdiodenanzeigevorrichtung nach Anspruch 8,
wobei die erste Farbschicht (540a), die zweite Farbschicht (540b) und die Schicht aus nur einer Farbe (550) jeweils unterschiedliche Farben aufweisen.

10. Organische Leuchtdiodenanzeigevorrichtung nach Anspruch 8 oder 9,
wobei eine Summe von Bereichen von Farbschichten, die dieselbe Farbe wie die erste Farbschicht (640a) aufweisen, eine Summe von Bereichen von Farbschichten, die dieselbe Farbe wie die zweite Farbschicht (640b) aufweisen, und eine Summe von Bereichen einfarbiger Schichten (650) zueinander gleich sind.

11. Vorrichtung nach einem der vorhergehenden Ansprüche, ferner umfassend eine schwarze Matrix (270), die an einer Grenze zwischen den Farbfilterschichten angeordnet ist.

12. Verfahren zum Herstellen einer der Vorrichtungen nach den vorhergehenden Ansprüchen, wobei die vierten Farbfilterschichten unter Verwendung einer Halbtonmaske gebildet werden.

13. Verfahren nach Anspruch 12, wobei das Verfahren ferner umfasst:
Herstellen einer Anzeigevorrichtung;
Beurteilen der Farbe, die wiedergegeben wird, wenn sich die Anzeigevorrichtung in einem schwarzen Zustand befindet; und
Anpassen des Herstellungsverfahrens durch Ändern der Dicke mindestens einer der vierten Farbfilterschichten, um das Aussehen des schwarzen Zustands zu verbessern.

## Revendications

1. Dispositif d'affichage à diodes électroluminescentes organiques (1000) comprenant un substrat incluant une pluralité de pixels, où chaque pixel comprend :
des sous-pixels rouge (SP210), blanc (SP110), vert (SP310) et bleu (SP410) ;
des première à troisième couches de filtre de couleur (210, 220, 230) disposées respectivement sur les sous-pixels rouge, vert et bleu ; et une quatrième couche de filtre de couleur (240), comprenant une couche de couleur dans le sous-pixel blanc ayant la même couleur que l'une quelconque des première à troisième couches de filtre de couleur, et ayant une plus petite épaisseur que les première à troisième couches de filtre de couleur ;
où la couleur de la couche de couleur alterne entre les pixels ;
le dispositif étant **caractérisé en ce qu'**au moins deux des quatrièmes couches de filtre de couleur (340, 350, 360) dans les pixels respectifs ont des épaisseurs différentes.

2. Dispositif d'affichage à diodes électroluminescentes organiques selon la revendication 1, dans lequel la diode électroluminescente organique comprend une première électrode (120), une couche électroluminescente organique, et une deuxième couche (150),
où la première électrode (120) est une électrode réfléchissante et la deuxième électrode est un matériau conducteur transparent.

3. Dispositif d'affichage à diodes électroluminescentes organiques selon l'une quelconque des revendications précédentes, dans lequel l'épaisseur des première à troisième couches de filtre de couleur est de 2 µm à 3 µm, et l'épaisseur des quatrième couches de filtre de couleur est de 0,1 µm à 1 µm.

4. Dispositif d'affichage à diodes électroluminescentes organiques selon l'une quelconque des revendications précédentes, dans lequel la couleur de la couche de couleur alterne dans une séquence qui comprend les couleurs bleue, verte et rouge.

5. Dispositif d'affichage à diodes électroluminescentes organiques selon la revendication 4, dans lequel :
la couche de couleur qui est bleue est configurée pour transmettre la lumière avec une longueur d'onde de 450 nm à 470 nm et absorber les autres longueurs d'ondes de la lumière ;
la couche de couleur qui est verte est configurée pour transmettre la lumière avec une longueur d'onde de 520 nm à 560 nm et absorber les autres longueurs d'ondes de la lumière ; et
la couche de couleur rouge est configurée pour transmettre la lumière avec une longueur d'onde de 620 nm à 640 nm et absorber les autres longueurs d'ondes de lumière.

6. Dispositif d'affichage à diodes électroluminescentes organiques selon l'une quelconque des revendications précédentes, dans lequel la couleur de la couche de couleur alterne selon une séquence répétitive.

7. Dispositif d'affichage à diodes électroluminescentes organiques selon l'une quelconque des revendications 1 à 3 et 6, dans lequel la quatrième couche de filtre de couleur est formée en stratifiant au moins deux couches de couleurs différentes (440a, 440b).

8. Dispositif d'affichage à diodes électroluminescentes organiques selon l'une quelconque des revendications précédentes,
dans lequel au moins deux des quatrièmes couches de filtre de couleur dans les pixels respectifs comprennent une première couche de couleur (540a) disposée sur une surface du substrat et une deuxième couche de couleur (540b) disposée pour être en contact avec une surface latérale de la première couche de couleur (540a), et
au moins une des quatrièmes couches de filtre de couleur dans les pixels respectifs comprend une couche d'une seule couleur (550).

9. Dispositif d'affichage à diodes électroluminescentes organiques selon la revendication 8,
dans lequel la première couche de couleur (540a), la deuxième couche de couleur (540b) et la couche d'une seule couleur (550) ont respectivement des couleurs différentes.

10. Dispositif d'affichage à diodes électroluminescentes organiques selon la revendication 8 ou la revendication 9,
dans lequel une somme de zones de couches de couleur ayant la même couleur que la première couche de couleur (640a), une somme de zones de couches de couleur ayant la même couleur que la deuxième couche de couleur (640b), et une somme de zones de couches d'une seule couleur (650) sont identiques les unes aux autres.

11. Dispositif selon l'une quelconque des revendications précédentes, comprenant en outre une matrice noire (270) disposée à une frontière entre les couches de filtre de couleur.

12. Procédé de fabrication de l'un quelconque des dispositifs des revendications précédentes, dans lequel les quatrièmes couches de filtre de couleur sont formées en utilisant un masque en demi-teinte.

13. Procédé selon la revendication 12, dans lequel le procédé comprend en outre :
la fabrication d'un dispositif d'affichage ;
l'évaluation de la couleur exprimée lorsque le dispositif d'affichage est dans un état noir ; et
l'ajustement du procédé de fabrication en changeant l'épaisseur d'au moins une des quatrièmes couches de filtre de couleur pour améliorer l'apparence de l'état noir.
